# EUROPÄISCHE PATENTANMELDUNG

(11) **EP 1 367 400 A2**
(43) Veröffentlichungstag der Anmeldung: **03.12.2003**
(21) Anmeldenummer: 03010989.6
(22) Anmeldetag: 16.05.2003
(51) Int. Cl.: G01R 1/073

(54) **Leiterplatten-Prüfeinheit**

(30) Priorität: 29.05.2002 DE 10223867
(71) Anmelder: ELCO Europe GmbH, D-57518 Betzdorf (DE)
(72) Erfinder: Maag, Arnulf, 57555 Muldersbach (DE)
(74) Vertreter: Valentin, Ekkehard, Dipl.-Ing.

(57) **Zusammenfassung**

Bei einer Platten-Prüfeinheit (1), umfassend eine elektrische Haupt-Leiterplatte (2), die in einem Anschlußbereich (3) über kontaktierende Einpreßstifte (16 a, 16 b) mit einer an eine Federleiste (10) angeschlossenen Nebenplatte (4 a, 4 b) verbunden ist, wobei zahlreiche eng aneinandergereihte, in ein Testgerät eingesetzte Platten-Prüfeinheiten (1) über in einer Geräte-Adapterplatte im Raster der Federleisten angeordneten, in die Federleisten (10) eintauchenden Messerstiften (11) an das Testgerät angeschlossen sind, ist der Haupt-Leiterplatte (2) im Anschlußbereich an jeder ihrer Breitseiten eine Nebenplatte (4 a, 4 b) zugeordnet und sind die Nebenplatten (4 a, 4 b) über zueinander gegensinnig eingesetzte Einpreßstifte (16 a, 16 b) mit der Haupt-Leiterplatte (2) verbunden.

## Beschreibung

Die Erfindung betrifft eine Platten-Prüfeinheit, umfassend eine elektrische Haupt-Leiterplatte, die in einem Anschlußbreich über kontaktierende Einpreßstifte mit einer an eine Federleiste angeschlossenen Nebenplatte verbunden ist, wobei zur Prüfung der elektrischen Durchgänge der Haupt-Leiterplatte zahlreiche eng aneinandergereiht in ein Testgerät eingesetzte Platten-Prüfeinheiten über in einer Geräte-Adapterplatte im Raster der Federleisten angeordneten, in die Federleisten eintauchenden Messerstiften an das Testgerät angeschlossen sind.

Derartige in einer Blockbauweise zusammengesetzten Platten-Prüfeinheiten ermöglichen es, zahlreiche elektrische Leiterplatten gleichzeitig in dem Testgerät auf deren elektrische Funktion zu prüfen. Zu diesem Zweck wird die gewünschte Anzahl an Platten-Prüfeinheiten in einem vorgegebenen Raster in Hochkantlage in dem Testgerät in Paketform zusammengesteckt. Das Testgerät besitzt eine durchgängig mit Strom versorgte Grund-Leiterplatte, an die die von den Federleisten entfernten Enden der Haupt-Leiterplatten mittels Steckverbindungen angeschlossen werden, während die Federleisten mit einer Geräte-Adapterplatte über deren Messerstifte, die in die Federkontakte der Federleiste eintauchen, verbunden werden. Die die Distanz von der Grund-Leiterplatte zu Anschluß oben im Testgerät überbrückenden Hauptplatten sind mit der Elektronik bestückt, die die Auswertung aufgrund der mit der Software des Gerätes hergestellten Verbindung übernimmt.

In der Praxis bekannte Platten-Prüfeinheiten sind mit Haupt-Leiterplatten versehen, deren Kontaktierungen mittels Lötung direkt mit dem Stecker verbunden sind.

Daraus ergibt sich, daß die Testgeräte nur mit gröberem Raster ausgestattet sind und somit nur ein solch grobes Raster getestet werden kann.

Der Erfindung liegt daher die Aufgabe zugrunde, eine gattungsgemäße Platten-Prüfeinheit ohne die genannten Nachteile zu schaffen, insbesondere bei unveränderten Abmessungen des Testgerätes ene höhere Prüfdichte zu erreichen.

Diese Aufgabe wird erfindungsgemäß dadurch gelöst, daß der Haupt-Leiterplatte im Anschlußbereich an jeder ihrer Breitseiten eine Nebenplatte zugeordnet ist und die Nebenplatten über zueinander gegensinnig eingesetzte Einpreßstifte mit der Hauptplatte verbunden sind. Es wird hiermit die Erkenntnis umgesetzt, daß sich die Polzahl bzw. die Testanschlüsse bei außerdem um die Hälfte reduziertem Rasterabstand, z.B. statt wie üblich 2,54 mm erfindungsgemäß nur noch 1,27 mm, verdoppeln lassen, was gleichermaßen für die Packungsdichte gilt, wenn zwei Nebenplatten vorgesehen werden, die jeweils für sich über zueinander gegensinnig bzw. -läufig eingesetzte Einpreßstifte mit der Haupt-Leiterplatte kontaktiert werden. An jeder der beiden Nebenplatten können für die in einer Reihe in der Haupterstreckung der Haupt-Leiterplatte wechselseitig bzw. gegensinnig eingesteckten Einpreßstifte zwei hinter- und nebeneinanderliegende Pole und somit für jede der parallel nebeneinander im Anschlußbereich auf der Haupt-Leiterplatte ausgebildeten Reihen vier Pole bzw. Anschlüsse vorgesehen werden. In Querrichtung der Haupt-Leiterplatte lassen sich in der Federleiste beispielsweise 128 (2 x 64) Pole ausbilden.

Eine Ausgestaltung der Erfindung sieht vor, daß den Nebenplatten in der Einpreßzone jeweils außen eine Distanzplatte vorgeschaltet ist, die mit den Köpfen der Einpreßstifte einen Anschlag bietenden Senkbohrungen ausgebildet sind. Die Einpreßstifte finden hiermit zur Kontaktierung eine definierte Anschlaglage und klemmen darüber hinaus die die Stabilität des Block-Verbundes fördernden Distanzplatten ein.

Nach einem weiteren Vorschlag der Erfindung sind den Nebenplatten innenseitig elektrisch sperrende Distanzstreifen zugeordnet. Diese Distanzstreifen tragen nicht nur zur weiteren Stabilisierung des Block-Verbundes der Platten-Prüfeinheit bei, sondern gewährleisten auch, daß stets nur die den in gleicher Richtung eingesetzten Einpreßstiften zugeordnete Nebenplatte kontaktiert wird. Eine gegenseitige Beeinflussung der Nebenplatten wird somit ausgeschlossen.

Wenn sich die Distanzstreifen vorteilhaft über den Anschlußbereich hinaus bis nahe zur Elektronik der Haupt-Leiterplatte erstrecken und ihre Verlängerungen außen von bündig mit den Distanzplatten verlaufenden Leisten überdeckt sind, läßt sich die Haupt-Leiterplatte, die üblich nicht dicker als 1 mm ist, ohne Einfluß auf die Elektronik stabilisieren.

Bei einer bevorzugten Ausführung der Erfindung sind für die Einpreßstifte einerseits in den Nebenplatten Einpreßzonen ausgebildet und andererseits sind ihnen in der Haupt-Leiterplatte Sockelkontakte zugeordnet, die entsprechend der gegensinnigen Orientierung der Einpreßstifte wechselseitig eingesteckt sind. Es lassen sich hierbei sogenannte Holetites als Sockelkontakte verwenden, die völlig in den Platten integriert sind und mit ihren freien Kontaktenden bzw. -fahnen in den ihnen je nach Einbaurichtung zugeordneten, dort mit Löchern versehenen Distanzplatten hineinragen, ohne dabei allerdings Kontakt mit der jeweils anderen Nebenplatte zu haben, weil ihre Einsteckenden unterhalb des jeweils benachbarten Distanzstreifens verlaufen.

Es ist erfindungsgemäß vorgesehen, daß in einem Steckbereich der Federleiste eingehauste Federkontakte an ihren aus dem Federleistengehäuse hinausragenden Enden mit den Nebenplatten verlötet sind. Die Lötverbindung stellt den elektrischen Kontakt sicher, der von den zur anderen Seite, d.h. zur Federleiste hin verlaufenden Federkontakten auf die von dort eintauchenden Messerstifte der Adapterplatte des Testgerätes weitergeleitet wird.

Nach einem bevorzugten Vorschlag der Erfindung sind die Federkontakte im doppelten Rasterabstand aus einem Blechzuschnitt ausgestanzt und durch Zu- bzw. Umklappen ihrer ausgestanzten Kontaktfahnen auf den Abstand des Rastermaßes in Position zueinander gebracht. Hierdurch ist es möglich, das ansonsten fertigungstechnisch durch Ausstanzen nicht zu erreichende, erfindungsgemäß sehr kleine Rastermaß von z.B. 1,27 mm einzuhalten, weil unverändert mit dem doppelten Abstand gestanzt werden kann und das kleine bzw. gegenüber dem Stanzmaß halbierte Raster danach durch das Zu- bzw. Umklappen eingehalten wird.

Weitere Einzelheiten und Vorteile der Erfindung ergeben sich aus den Ansprüchen und der nachfolgenden Beschreibung eines in den Zeichnungen dargestellten Ausführungsbeispiels der Erfindung. Es zeigen:
- Fig. 1: in einem sehr vergrößertem Maßstab eine Teil-Draufsicht einer Platten-Prüfeinheit;
- Fig. 2: im gleichen vergrößerten Maßstab wie in Fig. 1 im Teil-Querschnitt zwei aneinandergereihte Platten-Prüfeinheiten;
- Fig. 3: als Einzelheit der Fig. 2 den dort strichpunktiert gekennzeichneten Bereich "Z";
- Fig. 4: in einem noch weiter vergrößertem Maßstab eine Draufsicht auf ein Stanz-Streifenbild zur Herstellung von Federkontakten; und
- Fig. 5: als Einzelheit im Querschnitt einen aus dem Blechzuschnitt nach Fig. 4 durch Zu- bzw. Umklappen ausgebildeten, über Anschlußbeinchen mit einer Anschlußplatte der Prüf-Platteneinheit nach Fig. 1 verlöteten, von dem Federleisten-Gehäuse umgebenen Federkontakt.

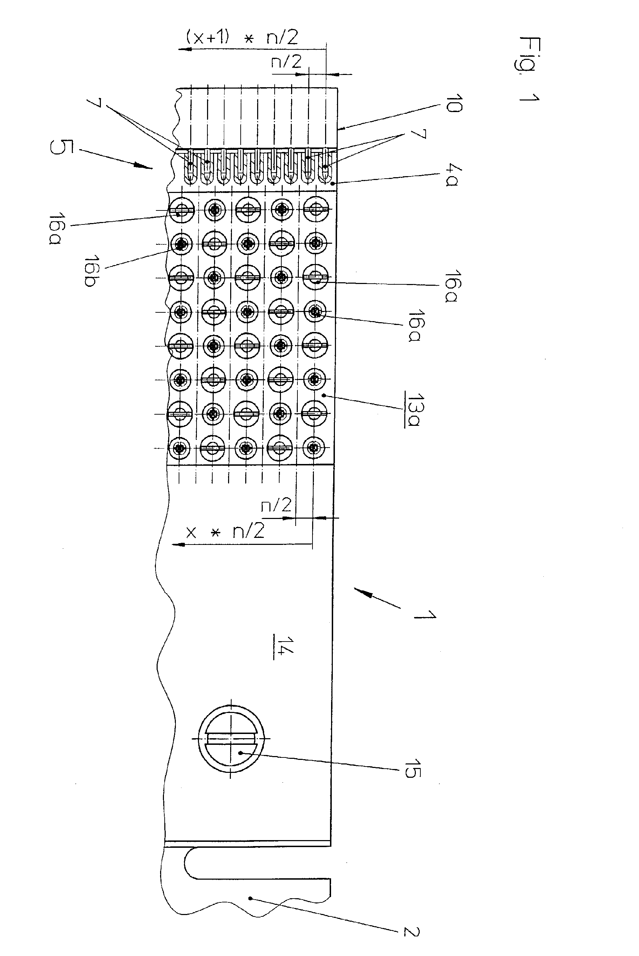

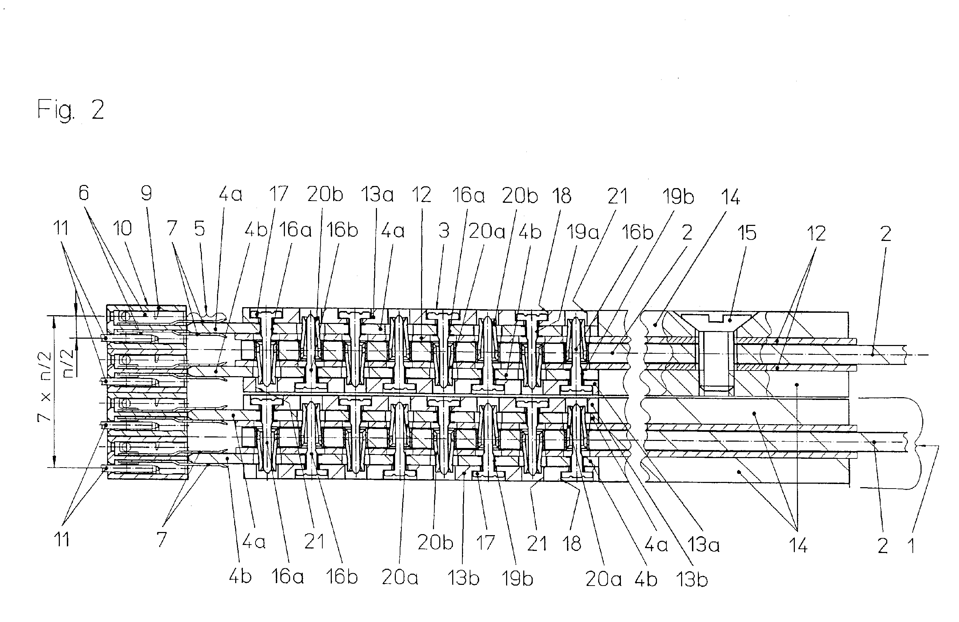

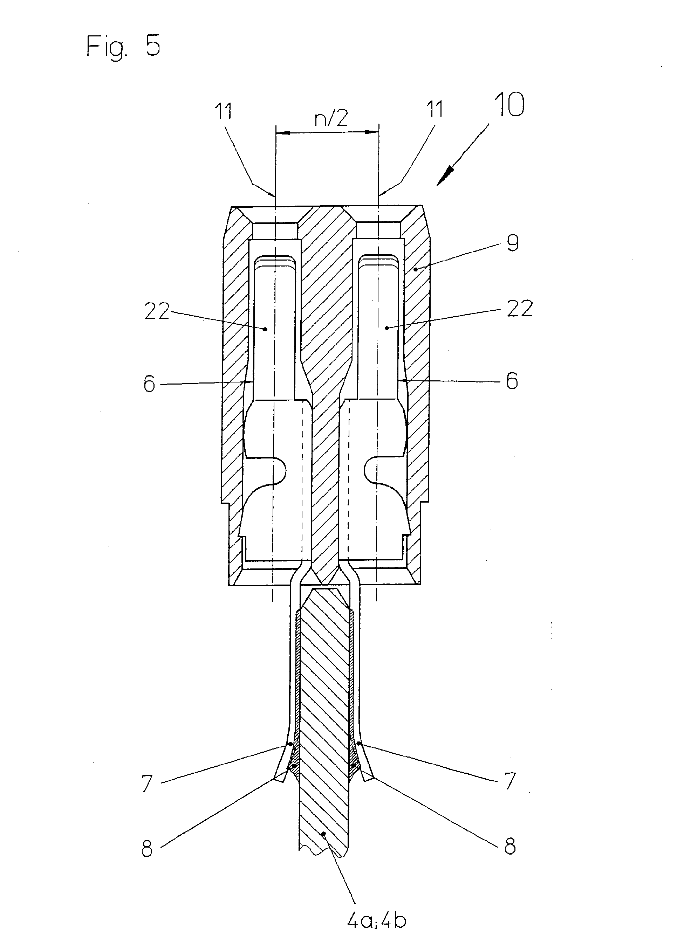

Eine in Fig. 1 in einer Teil-Draufsicht gezeigte Platten-Prüfeinheit 1 umfaßt eine Haupt-Leiterplatte 2, die in dem in Fig. 2 rechts liegenden, abgeschnittenen hinteren Bereich mit der Elektronik versehen ist und in einem vorderen Anschlußbereich 3 über einen größeren Längenabschnitt an ihren Breitseiten von je einer Nebenplatte 4a, 4b überdeckt wird. Diese kragen mit einem freien Ende gegenüber dem Plattenverbund vor und stellen dort einen Lötbereich 5 für an die Nebenplatten anzubringende Federkontakte 6 (vgl. Fig. 5) bereit (vgl. auch Fig. 2). Die im Lötbereich 5 mittels Anschlußbeinchen 7 über eine Lötmasse 8 (vgl. Fig. 5) an den Nebenplatten 4a, 4b befestigten Federkontakte 6 werden mit ihren freien Enden von einem Gehäuse 9 einer Federleiste 10 aufgenommen, die den Einsteckbereich für Messerstifte 11, wie in Fig. 2 angedeutet, definiert. Die Messerstifte 11 sind an einer kopfseitigen Adapterplatte eines nicht dargestellten Testgerätes angeordnet, in das zahlreiche Platten-Prüfeinheiten eng aneinandergereiht in Hochkantlage, d.h. in der Längsrichtung der Haupt-Leiterplatte 2 eingesetzt werden, wobei sich die Federleiste 10 oben befindet.

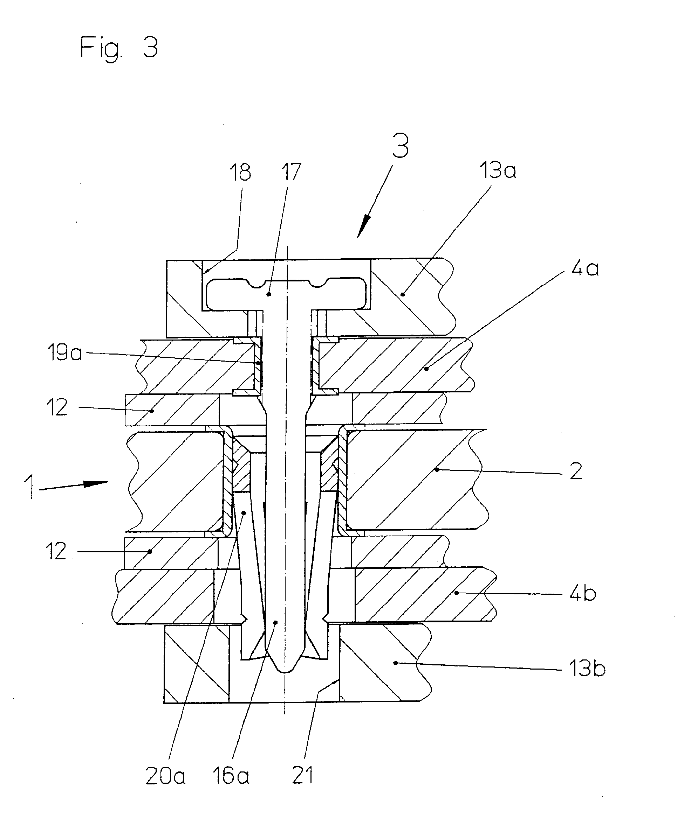

Der in Blockbauweise ausgeführte Verbund einer Platten-Prüfeinheit 1 ist näher der Fig. 2 in Verbindung mit Fig. 3 zu entnehmen. Der Verbund der Platten-Prüfeinheit 1 wird im Anschlußbereich 3 durch zwischen der Haupt-Leiterplatte 2 und den Nebenplatten 4a bzw. 4b angeordneten, elektrisch sperrenden Distanzstreifen 12 und jeweils außen von den Nebenplatten 4a, 4b vorgesehenen Distanzplatten 13a, 13b vervollständigt. Die Distanzstreifen 12 sind bis über den Anschlußbereich 3 hinaus verlängert und enden dort vor dem die Elektronik aufweisenden hauptsächlichen Längenabschnitt der Haupt-Leiterplatte 2. In diesem Zwischenabschnitt von Anschlußbereich 3 und Beginn der Elektronik der Haupt-Leiterplatte 2 sind die Distanzstreifen 12 von die Haupt-Leiterplatte 2 insgesamt stabilisiierenden, bündig zu den Distanzplatten 13a, 13b verlaufenden Leisten 14 eingefaßt. Die Leisten 14 mit den Distanzsteifen 12 sind mittels Befestigungsschrauben 15 mit der Haupt-Leiterplatte 2 verbunden.

Zur Kontaktierung der Nebenplatten 4a, 4b der Haupt-Leiterplatten sind im Anschlußbereich 3 der Haupt-Leiterplatten 2 in abwechselnd gegensinniger Einbaulage - ausgehend jeweils von den Distanzplatten 13a bzw. 13b - den gesamten Plattenverbund durchdringende Einpreßstifte 16a bzw. 16b eingesetzt. Diese finden einerseits mit ihren Köpfen 17 in Senkbohrungen 18 der Distanzplatten 13a bzw. 13b definierte Endanschläge und andererseits in den Nebenplatten ausgebildete, massive Einpreßzonen 19a, 19b vor. Die voneinander isolierte elektrische Verbindung der Haupt-Leiterplatte 2 mit zum einen der Nebenplatte 4a und zum anderen der Nebenplatte 4b wird durch analog zur Einbaulage der Einpreßstifte 16a bzw. 16b, d.h. ebenso gegensinnig in die Haupt-Leiterplatte 2 eingesetzte Sockelkontakte 20a bzw. 20b, erreicht. Diese enden übereinstimmend mit den dazugehörigen Einpreßstiften 16a oder 16b in entsprechend dem Rastermaß der eingesetzten Einpreßstifte 16a, 16b in die Distanzplatten 13a bzw. 13b eingearbeitete Durchgangsbohrungen 21.

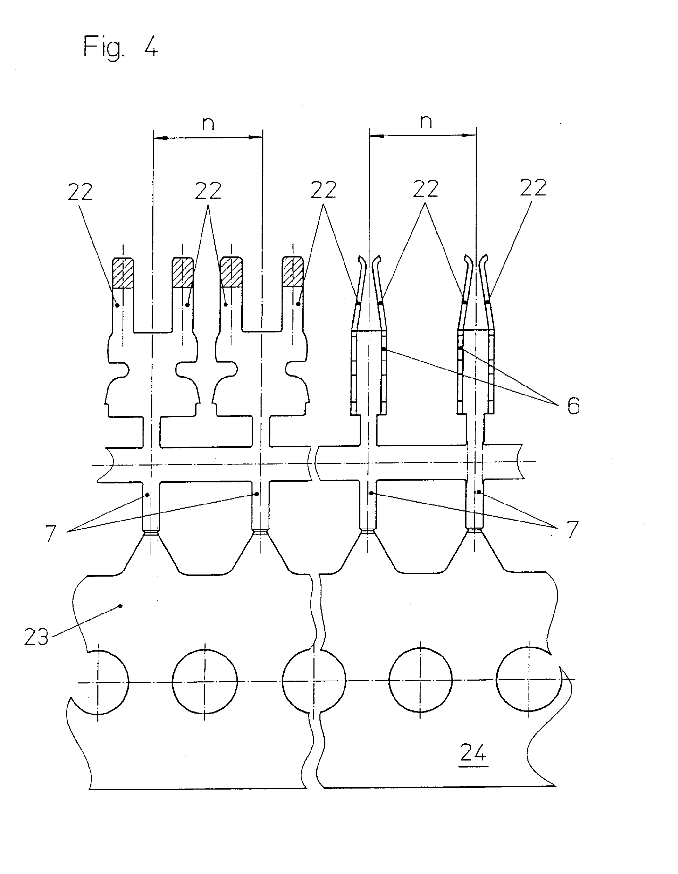

Aus der Fig. 2 ist zu erkennen, daß der Rasterabstand der gegensinnig eingesetzten Einpreßstifte 16a, 16b in Längsorientierung der Platten-Prüfeinheit 1 bzw. der Haupt-Leiterplatte 2 zwar in dem Maß n vorgesehen ist, jedoch die erreichte Anbringung von zwei Nebenplatten 4a, 4b einen Polabstand von n/2 ermöglicht, d.h. z.B. 1,27 mm bei einem Raster n von 2,54 mm. Denn an beiden Nebenplatten 4a bzw. 4b können Federkontakte 6 vorgesehen werden, die nebeneinanderliegend und aufgrund des Zusammenspiels mit der jeweils anderen Nebenplatte 4a bzw. 4b untereinanderliegend aus jeweils zwei zusammenwirkenden Kontaktfahnen 22 (vgl. Fig. 4) bestehende und somit insgesamt vier Einsteckkontakte für die Messerstifte 11 (vgl. die Fig. 1 und 5) bereitstellen. Auf diese Weise läßt sich beispielsweise eine aus 2 x 64 Polen und somit 128-polige Federleiste 10 für eine Haupt-Leiterplatte 2 einer Platten-Prüfeinheit 1 ausbilden.

Damit sich solch eng beabstandete Einsteckkontakte bzw. Federkontakte durch Stanzen fertigungstechnisch überhaupt herstellen lassen, werden Kontaktfahnen 22 aus einem in Fig. 4 teilweise gezeigten Blechzuschnitt 23 entsprechend dem dargestellten Streifenbild im Rastermaß n ausgestanzt, dann zunächst die beiden komplementären Kontaktfahnen 22 aufeinander zu geklappt, wie in der rechten Bildhälfte von Fig. 4 gezeigt, und danach die Federkontakte selbst aufeinander zu geklappt. Im Montagezustand liegt dann eine in Fig. 5 dargestellte Kontakteinheit mit nur noch im Abstand n/2 liegenden, Pole bzw. Einsteckkontakte bildenden Paaren von Kontaktfahnen 22 vor. Vor dem Zuklappen der Kontaktfahnen 22 bzw. der Federkontakte 6 wird aus dem Blechzuschnitt 23 die Mittenanbindung 24 herausgetrennt und der Blechzuschnitt auf die gewünschte Polzahl in Streifen geschnitten.

## Patentansprüche

1. Platten-Prüfeinheit, umfassend eine elektrische Haupt-Leiterplatte, die in einem Anschlußbereich über kontaktierende Einpreßstifte mit einer an eine Federleiste angeschlossenen Nebenplatte verbunden ist, wobei eng aneinandergereihte, in ein Testgerät eingesetzte Platten-Prüfeinheiten über in einer Geräte-Adapterplatte im Raster der Federleisten angeordneten, in die Federleisten eintauchenden Messerstiften an das Testgerät angeschlossen sind,
**dadurch gekennzeichnet,**
**daß** der Haupt-Leiterplatte (2) im Anschlußbereich (3) an jeder ihrer Breitseiten eine Nebenplatte (4a, 4b) zugeordnet ist und die Nebenplatten (4a, 4b) über zueinander gegensinnig eingesetzte Einpreßstifte (16a, 16b) mit der Haupt-Leiterplatte (2) verbunden sind.

2. Platten-Prüfeinheit nach Anspruch 1,
**dadurch gekennzeichnet,**
**daß** den Nebenplatten (4a, 4b in dem Anschlußbereich (3) jeweils außen eine Distanzplatte (13, 13b) vorgeschaltet ist, die mit den Köpfen (17) der Einpreßstifte (16a, 16b) einen Anschlag bietenden Senkbohrungen (18) ausgebildet sind.

3. Platten-Prüfeinheit nach Anspruch 1 oder 2,
**dadurch gekennzeichnet,**
**daß** den Nebenplatten (4a, 4b) innen elektrisch sperrende Distanzstreifen (12) zugeordnet sind.

4. Platten-Prüfeinheit nach Anspruch 2 oder 3,
**dadurch gekennzeichnet,**
**daß** die Distanzstreifen (12) sich über den Anschlußbereich (3) hinaus bis nahe zur Elektronik der Haupt-Leiterplatte (2) erstrecken und ihre Verlängerungen außen von bündig mit den Distanzplatten (13a, 13b) verlaufenden Leisten (14) überdeckt sind.

5. Platten-Prüfeinheit nach einem der Ansprüche 1 bis 4,
dad urch **gekennzeichnet**,
daß für die Einpreßstifte (16a, 16b) einerseits in den Nebenplatten (4a, 4b) Einpreßzonen (19a, 19b) ausgebildet sind und ihnen andererseits in der Haupt-Leiterplatte (2) Sockelkontakte (20a, 20b) zugeordnet sind, die entsprechend der gegensinnigen Orientierung der Einpreßstifte (16a, 16b) wechselseitig eingesteckt sind.

6. Platten-Prüfeinheit nach einem der Ansprüche 1 bis 5,
**dadurch gekennzeichnet,**
**daß** in einem Steckbereich der Federleiste (10) eingehauste Federkontakte (6) an ihren aus dem Federleistengehäuse (9) hinausragenden Enden mit den Nebenplatten (4a, 4b) verlötet sind.

7. Platten-Prüfeinheit nach Anspruch 6,
**dadurch gekennzeichnet,**
**daß** die Federkontakte (6) im doppelten Rasterabstand aus einem Blechzuschnitt (23) ausgestanzt und durch Zu- bzw. Umklappen ihrer ausgestanzten Kontaktfahnen (22) auf den Abstand des Rastermaßes (n/2) in Position zueinander gebracht sind.
